# EUROPÄISCHE PATENTSCHRIFT

(11) **EP 1 635 403 B1**
(45) Veröffentlichungstag und Bekanntmachung des Hinweises auf die Patenterteilung: **03.04.2013**
(21) Anmeldenummer: 04405558.0
(22) Anmeldetag: 08.09.2004
(51) Int. Cl.: H01L 33/00

(54) **Isoliertes Metallsubstrat mit mehreren Leuchtdioden**
Metallic substrate with multiple light emitting diodes
Substrat métallique avec plusieurs diodes luminescentes

(43) Veröffentlichungstag der Anmeldung: 15.03.2006
(73) Patentinhaber: Asetronics AG, 3018 Bern 18 (CH)
(72) Erfinder: Furrer-Hügin, Joseph, 4533 Riedholz (CH); Hefti-Baumann, Peter, 2504 Biel (CH); Weber-Haas, Walter, 3184 Wünnewil (CH)
(74) Vertreter: Rutz & Partner

(56) Entgegenhaltungen:
- WO-A-03/030274
- JP-A- 61 116 702
- US-A- 4 935 665
- US-A1- 2003 072 153
- US-A1- 2004 065 894
- PATENT ABSTRACTS OF JAPAN Bd. 0121, Nr. 06 (E-596), 6. April 1988 (1988-04-06) & JP 62 235787 A (KOITO MFG CO LTD), 15. Oktober 1987 (1987-10-15)
- PATENT ABSTRACTS OF JAPAN Bd. 2000, Nr. 19, 5. Juni 2001 (2001-06-05) & JP 2001 036153 A (MATSUSHITA ELECTRIC WORKS LTD), 9. Februar 2001 (2001-02-09)

## Beschreibung

Die Erfindung betrifft ein isoliertes Metallsubstrat mit mehreren Leuchtdioden, insbesondere LED-Chips, nach dem Oberbegriff des Patentanspruchs 1.

Wie in [1], US 6,498,355 B1 beschrieben, werden Leuchtdioden (LED's), insbesondere LED-Matrizen, mittlerweile in verschiedenen Anwendungsbereichen (Strassenverkehrstechnik, Beleuchtung, Signalisierung) eingesetzt. In diesen Anwendungsbereichen werden daher LED-Matrizen gefordert, die eine hohe spezifische Ausstrahlung, d.h. eine hohe Strahlungsleistung pro Sendefläche aufweisen. Die spezifische Ausstrahlung kann durch Erhöhung der Dichte der in einer LED-Matrix enthaltenen Leuchtdioden sowie durch Erhöhung der Strahlungsleistungen der einzelnen Leuchtdioden erhöht werden. Bei beiden Lösungswegen zur Erhöhung der spezifischen Ausstrahlung treten höhere Verlustleistungen auf, die eine Erwärmung der LED-Matrix verursachen. Um eine Zerstörung oder Leistungsbeeinträchtigung der in der LED-Matrix enthaltenen Leuchtdioden zu vermeiden, ist die Verlustwärme daher effizient abzuleiten.

Dazu wird in [1] vorgeschlagen, die Leuchtdioden auf einem isolierten Metallsubstrat anzuordnen, auf dem elektrisch leitende Bahnen vorgesehen sind, die durch eine dielektrische Isolationsschicht vom Metallsubstrat getrennt sind. Wie in [2], US 5, 513,072 beschrieben, wird bei einem derartigen isolierten Metallsubstrat (Insulated Metal Substrate IMS) eine stark wärmeabstrahlende und gut wärmeleitende Isolationsschicht verwendet, so dass Verlustwärme über das Metallsubstrat effizient abgeleitet wird. Zur Verbesserung des Wärmetransfers wird in [1] zudem vorgeschlagen, gut wärmeleitende Verbindungen (sogenannte Vias) durch die Isolationsschicht hindurch zu führen. Jeder Leuchtdiode einer LED-Matrix, deren elektrische Anschlussleitungen an Anschlusskontakte mit entsprechendem elektrischem Potential angeschlossen sind, ist dabei ein solcher thermischer Verbindungskontakt zugeordnet. Mit der in [1] offenbarten Lösung gelingt es daher, die Packungsdichte und, aufgrund der effizienten Ableitung der Verlustwärme, gleichzeitig die Strahlungsleistung zu erhöhen. Zu beachten ist jedoch, dass durch den Einbau der thermischen Verbindungskontakte ein zusätzlicher Fertigungsaufwand resultiert.

Zur Bündelung und Leitung des von den Leuchtdioden emittierten Lichts wird in [1] die Verwendung von Linsen vorgeschlagen, die aus klarem Kunststoff oder Elastomer gefertigt, auf die LED-Chips gegossen oder gepresst werden. Alternativ können hohle, klare Linsen auf die LED-Chips aufgesetzt, verleimt oder umspritzt werden. Möglich ist ferner die Verwendung von Elementen aus Silikon oder weiteren Stoffen, die auf die LED-Chips aufgebracht und dann zur Ausbildung einfacher Linsen ausgehärtet werden. Diese Fertigungsprozesse sind wiederum mit einem erheblichen Aufwand verbunden. Zudem nimmt das Aushärten der Materialien entsprechend Zeit in Anspruch.

Aus [3], US 4,935,665 ist eine Lampe mit Leuchtdioden bekannt, die ein isoliertes Metallsubstrat mit Vertiefungen aufweist, in denen die Leuchtdioden angeordnet sind. Die von den Leuchtdioden abgegeben und von den Wänden der Vertiefungen reflektierte Strahlung wird mittels einer Platte mit optischen Linsen gesammelt und abgestrahlt. Dadurch resultiert eine verbesserte Bündelung der optischen Abstrahlung mit weniger Streulichtverlusten und einem gleichzeitig verbesserten Wärmetransfer von den Leuchtdioden zum Metallsubstrat. Die Ausrichtung der Strahlung erfolgt daher mittels der genannten Platte.

Aus [4], WO 03/030274 ist ein mit Leuchtdioden bestücktes isoliertes Metallsubstrat bekannt, bei dem Vertiefungen in Seite des Metallsubstrats derart eingeprägt sind, dass auf der anderen Seite insular die Ausbuchtungen resultieren. Damit die Wärme von diesem Metallsubstrat gut abgeführt werden kann, ist daher eine an das Metallsubstrat angepasste weitere Metallplatte erforderlich. Weiterhin erlaubt dieses Metallsubstrat kleine Abstrahlung des von den Leuchtdioden abgegebenen Lichts in verschiedene Richtungen.

Aus [5], WO 03/030274 ist weiteres mit Leuchtdioden bestücktes isoliertes Metallsubstrat bekannt, welches jedoch auch nicht erlaubt, dass von den Leuchtdioden abgegebene Licht in verschiedene Richtungen abzustrahlen.

Aufgrund der mittlerweile weiter erhöhten Strahlungsleistungen der Leuchtdioden wäre eine weiter verbesserte Wärmeableitung jedoch wünschenswert. Ferner wäre es wünschenswert, wenn unter Aufrechterhaltung eines optimalen Transfers der Verlustwärme der Leuchtdioden eine flexiblere Ausrichtung der von den Leuchtdioden abgegebenen Strahlung erzielt werden könnte.

Der vorliegenden Erfindung liegt daher die Aufgabe zugrunde, diese bekannten Vorrichtungen weiter zu verbessern.

Insbesondere ist ein verbessertes isoliertes Metallsubstrat mit mehreren darauf montierten Leuchtdioden anzugeben, welches erlaubt Leuchtdioden, insbesondere LED-Chips, mit höheren Strahlungsleistungen und höheren Packungsdichten zu verwenden. Ferner soll das verbesserte isolierte Metallsubstrat erlauben, die von den Leuchtdioden abgegebene Strahlung wahlweise, vorzugsweise sektoriell, auszurichten.

Die Lösung dieser Aufgabe gelingt mit einem isolierten Metallsubstrat nach dem Oberbegriff des Patentanspruchs 1.

Das isolierte Metallsubstrat besteht aus einem mit mehreren Vertiefungen versehenen Metallsubstrat, vorzugsweise aus Aluminium, Aluminiumlegierungen oder Kupfer, an dessen Oberseite eine Isolationsschicht mit elektrischen Bahnen angeordnet ist, an die mehrere gegebenenfalls in Chip-Form vorliegende, innerhalb den Vertiefungen angeordnete Leuchtdioden angeschlossen sind. Erfindungsgemäss sind die als Reflektor dienenden, beschichteten oder unbeschichteten Vertiefungen derart an der Oberseite in das Metallsubstrat eingearbeitet, dass dessen Unterseite eine ebene Fläche bildet, die mit einem Metallelement verbunden oder verbindbar ist, das die von den Leuchtdioden abgegebene Wärmeenergie absorbiert.

Die Vertiefungen werden beispielsweise in das Metallsubstrat eingefräst, eingebohrt und/oder eingeprägt, dass auf der gegenüberliegenden Seite des Metallsubstrats keine Verbiegungen resultieren und das Metallsubstrat flächig mit dem Metallelement verbunden werden kann. Das Metallsubstrat kann mit den Vertiefungen auch mittels eines Giessverfahrens gefertigt werden.

Um einen optimalen Wärmetransfer von den Leuchtdioden bzw. von den LED-Chips zum Metallsubstrat zu gewährleisten wird vorzugsweise wenigstens ein elektrischer Anschlusskontakt oder ein thermischer Anschlusskontakt der LED-Chips mit dem Metallsubstrat verbunden, vorzugsweise verlötet. Um einen optimalen Wärmetransfer vom Metallsubstrat zum Metallelement zu gewährleisten, werden das Metallsubstrat und das Metallelement fest miteinander verbunden, vorzugsweise verschraubt, verstemmt oder verlötet. Das Metallsubstrat dient daher nicht primär der Aufnahme der von den Leuchtdioden abgegebenen Wärmeenergie, sondern hauptsächlich dem Transfer derselben zum angeschlossenen Metallelement. Es sind daher dünne Metallsubstrate verwendbar, deren Dicke nur wenig grösser ist als die Tiefe der Vertiefungen. Besonders vorteilhaft dabei ist, dass isolierte Metallsubstrate mit diesen dünnen Metallsubstraten bei der Herstellung oder anwenderseitig aufgrund kleiner resultierender Biegeradien und/oder sektoriellem Biegen problemlos in eine gewünschte Form biegbar sind. Aufgelötete Komponenten und ihre Lötstellen werden dabei nicht oder nur minimal belastet. Es sind daher flexible isolierte Metallsubstrate mit n miteinander verbundenen Teilen herstellbar, die nach entsprechendem Biegen unterschiedliche Strahlungsachsen und an der Unterseite je eine ebene Fläche aufweisen, durch die ein optimaler Wärmetransfer gewährleistet wird.

Um das Biegen zu Erleichtern sind die gegeneinander biegbaren Teile des Metallsubstrats zumindest teilweise durch Schnitte und/oder Materialausnehmungen, wie Kerben oder Nuten, voneinander getrennt. Dabei werden die Materialausnehmungen vorzugsweise an der Unterseite des Metallsubstrats vorgesehen, um die Biegelinie, beispielsweise eine Biegeachse möglichst weit gegen die Isolationsschicht zu verschieben und kleine Biegeradien zu erzielen. Die auf dem Metallsubstrat vorgesehenen Schichten und elektrischen Bahnen werden durch den Biegevorgang daher nur minimal gedehnt.

Um Leitungsunterbrüche zu vermeiden, werden die elektrischen Bahnen im Bereich möglicher Biegezonen auf der zugehörigen Isolationsschicht vorzugsweise schräg verlaufend, kurvenförmig oder zackenförmig angeordnet. Dadurch werden bei stärkeren Biegungen Unterbrüche an den Leiterbahnen vermieden. Grössere Biegewinkel sind erzielbar, sofern Isolationsschichten aus elastischem Material verwendet werden. Besonders vorteilhaft sind dehnbare Brückenelemente verwendbar, mittels denen im Biegebereich unterbrochene Leiterbahnen überbrückt werden. Diese Brückenelemente, die während des Bestückungsprozess mittels Löttechnik mit den vorzugsweise aufgetrennten Leiterbahnen verbunden werden, weisen beispielsweise zwei verlötbare Anschlüsse auf, die durch ein elastisches Metallelement miteinander verbunden sind. Beispielsweise sind gebogene platten- oder drahtförmige Metallelemente verwendbar.

Die im Metallsubstrat vorgesehenen Vertiefungen können rund, oval oder auch kanalförmig ausgestaltet sein. Bei der Verwendung kanalförmiger Vertiefungen kann die Packungsdichte der Leuchtdioden weiter erhöht werden. Die Biegelinien zwischen den gegeneinander biegbaren Teilen des isolierten Metallsubstrats verlaufen dabei vorzugsweise parallel zwischen zwei Kanälen.

In vorzugsweisen Ausgestaltungen sind an der Oberseite des Metallsubstrats wenigstens zwei übereinander liegende erste bzw. zweite Isolationsschichten mit elektrischen Bahnen angeordnet. Einzelne der Bahnen der verschiedenen Isolationsschichten sind dabei mittels so genannter Vias miteinander verbunden, die wenigstens eine der Isolationsschichten durchdringen. Die elektrischen Bahnen der ersten Schicht sind daher vorteilhaft zur Kontaktierung der Leuchtdioden verwendbar. Elektronische Bauteile, die beispielsweise der Ansteuerung der Leuchtdioden dienen, werden hingegen vorzugsweise mittels der auf der zweiten Isolationsschicht vorgesehenen elektrischen Bahnen verschaltet. In weiteren vorzugsweisen Ausgestaltungen wird ein mehrschichtiger Aufbau nur ausserhalb der Biegezonen vorgesehen.

Die Erfindung wird nachstehend anhand von Zeichnungen näher erläutert. Dabei zeigt in Schnittdarstellung:
- Figur 1: eine bekannte Anordnung eines LED-Chips 2 auf einem isolierten Metallsubstrat 1000;
- Figur 2: ein in der Internationalen Patentanmeldung PCT/CH 03 /00351 beschriebenes isoliertes Metallsubstrat 1001 bestehend aus einem mit einer Vertiefung 121 versehenen Metallsubstrat 12, an dessen Oberseite eine Isolationsschicht 11 mit elektrischen Bahnen 10 angeordnet ist, an die eine in Chip-Form vorliegende, innerhalb der Vertiefung 121 angeordnete Leuchtdiode 2 angeschlossen ist;
- Figur 3: ein isoliertes Metallsubstrat 1, dessen Metallsubstrat 12 einerseits mit einem Metallelement 120 und andererseits mit einem elektrischen Kontakt 22 eines LED-Chips 2 mittels einer Lotschicht 13 verlötet ist;

- Figur 4: ein isoliertes Metallsubstrat 1 mit einem Aufbau von mehreren Isolationsschichten 11, 11' deren elektrische Bahnen 10, 10' mittels eines durch die untere Isolationsschicht 11 hindurch geführten Kontakts bzw. eines Via 15 miteinander verbunden sind;
- Figur 5: ein isoliertes Metallsubstrat 1 in einer weiteren Ausgestaltung mit einer von unten in das Metallsubstrat 12 eingearbeiteten Biegenut 125 über der ein Teil 105 der elektrischen Bahnen 10 brückenartig verläuft;
- Figur 6: das isolierte Metallsubstrat 1 von Figur 5 mit mehreren Vertiefungen 121 für LED-Chips;
- Figur 7: das isolierte Metallsubstrat 1 von Figur 6 mit zwei gegen einander gebogenen Teilen 1A, 1B; und
- Figur 8: in einer vorzugsweisen Ausgestaltung ein isoliertes Metallsubstrat 1 mit zwei kanalförmigen Vertiefungen 121', zwischen denen eine Biegelinie B verläuft.

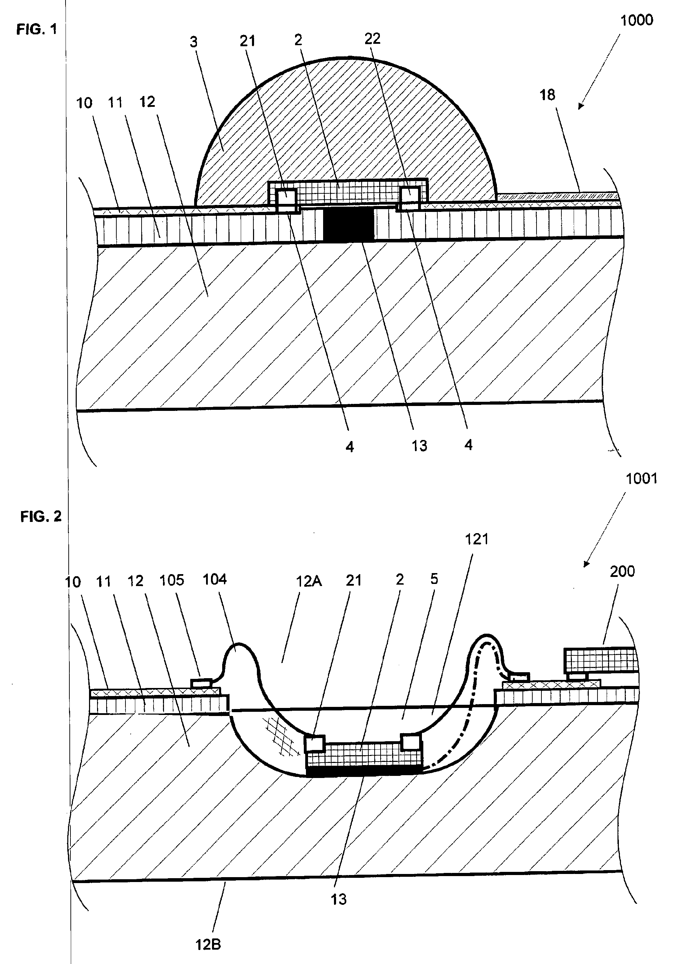

Figur 1 zeigt eine beispielsweise aus [1] bekannte Anordnung eines LED-Chips 2 auf einem isolierten Metallsubstrat 1000. Das isolierte Metallsubstrat 1000 besteht aus einem Metallsubstrat 12, einer dielektrischen Isolationsschicht 11 und auf der Isolationsschicht 11 vorgesehenen elektrischen Bahnen 10, an die ein auf einem wärmeleitenden Element 13 ruhender LED-Chip 2 angeschlossen ist. Gezeigt sind ferner die mittels eines Lötmittels 4 verbundenen elektrischen Anschlusskontakte 21, 22 des LED-Chips 2 sowie eine Lackmaske 18 als Löt und Oberflächenschutz. Die vom LED-Chip 2 abgegebene thermische Energie wird mittels des wärmeleitenden Elements 13 vom LED-Chip 2 zum Metallsubstrat 12 transferiert. Zur Verbesserung der Abstrahleigenschaften ist ferner eine Linse oder eine Glaskappe 3 vorgesehen.

Figur 2 zeigt ein in der Internationalen Patentanmeldung PCT/CH 03 /00351 beschriebenes isoliertes Metallsubstrat 1001 mit einem Metallsubstrat 12, einer Isolationsschicht 11 mit elektrischen Bahnen 10 und mit einem LED-Chip 2, der in einer Vertiefung 121 angeordnet ist, deren Wände als Reflektor 5 dienen. Der LED-Chip 2 ist mittels eines Klebers 13 mit dem Metallsubstrat 12 und dessen Anschlusskontakte 21 sind mittels Bonddrahtstellen 104 mit Anschlusskontakten 105 auf den elektrischen Bahnen 10 verbunden.

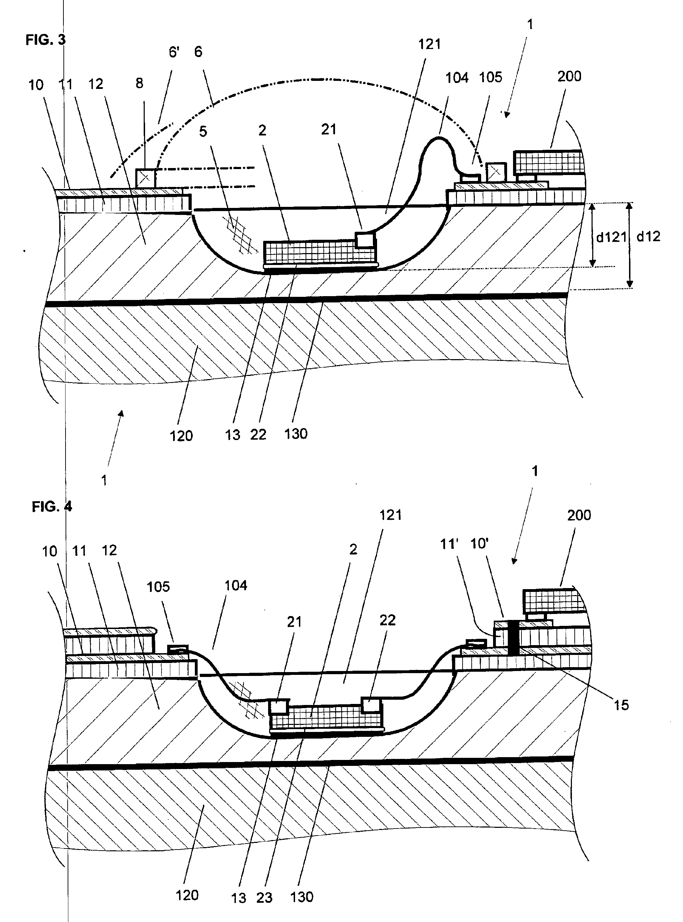

Figur 3 zeigt ein isoliertes Metallsubstrat 1, dessen Metallsubstrat 12 einerseits mit einem Metallelement 120 und andererseits mit einem grossflächigen elektrischen Kontakt 22 eines LED-Chips 2 verlötet ist. Der zweite elektrische Kontakt 21 des LED-Chips 2 ist über eine Drahtbondstelle mit einem Anschlusskontakt 105 auf den elektrischen Bahnen 10 der Isolationsschicht verbunden.

Das Metallsubstrat 12 des in Figur 3 gezeigten dient daher nicht primär der Aufnahme der vom LED-Chip 12 abgegebenen Wärmeenergie, sondern hauptsächlich dem Transfer derselben zum angeschlossenen Metallelement 120. Es sind daher dünne Metallsubstrate 12 verwendbar, deren Dicke d12 etwa der Tiefe d121 der Vertiefungen 121 entspricht. Besonders vorteilhaft dabei ist, dass isolierte Metallsubstrate 1 mit diesen dünnen Metallsubstraten 12 bei der Herstellung oder auch anwenderseitig problemlos in eine gewünschte Form biegbar sind, so dass ein isoliertes Metallsubstrat mit n miteinander verbundenen Teilen 1A, 1B, ..., die unterschiedliche Strahlungsachsen aufweisen, leicht herstellbar ist, ohne dass optische Elemente benötigt werden. Die Erfindung erlaubt daher die Herstellung flexibler Metallsubstrate, die beispielsweise anwenderseitig mit einem Metallelement eines hergestellten Produkts, beispielsweise eines Fahrzeugs verbindbar sind.

In der in Figur 4 gezeigten Ausgestaltung des isolierten Metallsubstrats 1 sind beide elektrischen Kontakte 21, 22 des LED-Chips mit elektrischen Bahnen 10 verbunden, die auf einer ersten Isolationsschicht 11 vorgesehen sind. Die elektrischen Bahnen 10 der ersten Isolationsschicht 11 sind mittels Vias 15, die durch die erste Isolationsschicht 11 hindurch geführt sind, mit elektrischen Bahnen 10' einer zweiten Isolationsschicht 11' verbunden, an die elektrische und/oder elektronische Bauteile 200 angeschlossen sind. Durch den gezeigten Schichtaufbau kann die Beschaltung der Leuchtdioden 2 von der Beschaltung der elektronischen Bauteile 200 somit vorteilhaft getrennt werden. Zudem kann eine geringe Bauhöhe des isolierten Metallsubstrats 1 erzielt werden, da die Verdrahtung der LED-Chips 2 auf der ersten Isolationsschicht 11 erfolgt. Der LED-Chip 2 von Figur 4 weist ferner einen thermischen Anschlusskontakt 23 auf, der mittels einer Lotschicht 13 grossflächig mit dem Metallsubstrat 12 verbunden ist, um einen optimalen Wärmetransfer zu gewährleisten.

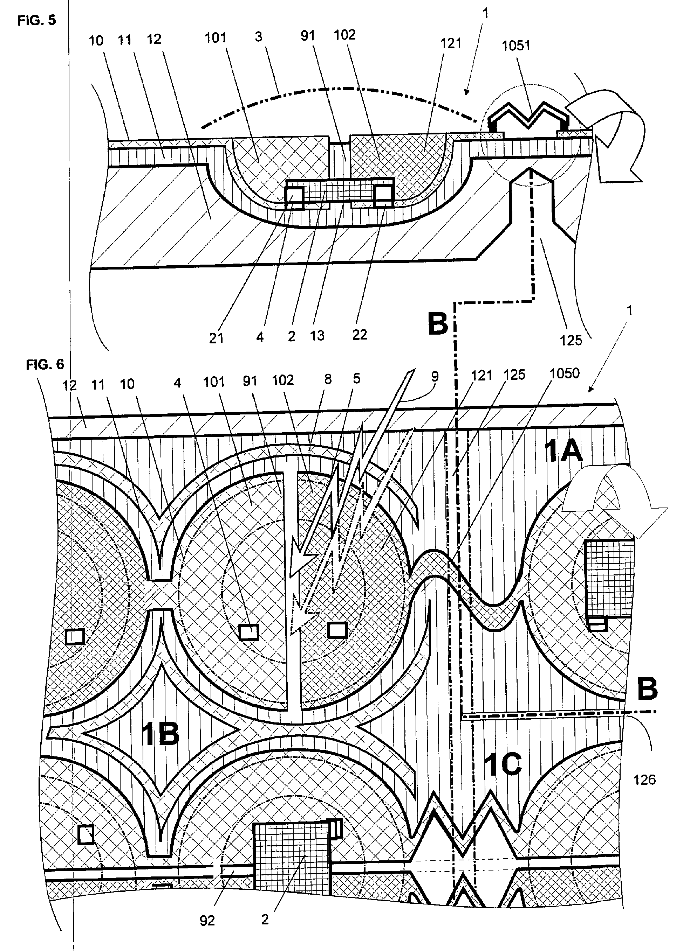

Figur 5 zeigt ein isoliertes Metallsubstrat 1 in einer weiteren vorzugsweisen Ausgestaltung mit einer von unten in das Metallsubstrat 12 eingearbeiteten Biegenut 125 über der die elektrischen Bahnen 10 aufgetrennt und mittels eines dehnbaren, gegebenenfalls elastischen Brückenelements 1051 überbrückt sind. Durch das Einarbeiten der Biegenut 125 wird die Biegeachse weit gegen die Isolationsschicht 11 verschoben, so dass nur kleine Biegeradien resultieren und die auf dem Metallsubstrat 12 vorgesehenen Schichten 10, 11, sofern vorhanden, oder das Brückenelement 1051, sofern vorhanden, nur einer geringen Dehnung unterworfen werden. Bei der Biegung des isolierten Metallsubstrats 1 wird das Brückenelement 1051 gedehnt, ohne dass ein Leitungsunterbruch oder störende, auf die Schichten 10, 11 des isolierten Metallsubstrats 1 einwirkende mechanische Spannungen entstehen können. Die Biegenut 125 und das Brückenelement 1051 sowie nachstehend beschriebene alternative Lösungen sind unabhängig von der Art der Montage und Kontaktierung der LED-Chips 2, also auch in den Ausgestaltungen von Figur 3 und Figur 4 vorteilhaft realisierbar.

Das in Figur 5 gezeigte Metallsubstrat 12 ist vollständig mit der Isolationsschicht 11 bedeckt, die auch in die Vertiefung 121 hineingezogen ist. Ebenfalls in die Vertiefung 121 hineingezogen ist die der Bildung der elektrisch leitenden Bahnen 10 dienende Metallschicht. Etwa in der Mitte der Vertiefung 121 ist diese Metallschicht durch eine Aussparung 91 aufgetrennt, so dass zwei voneinander elektrisch getrennte Anschlussleitungen 101, 102 resultieren, die die Vertiefung 121 fast vollständig bedecken und einen Reflektor bilden.

Figur 6 zeigt das isolierte Metallsubstrat 1 von Figur 5 mit mehreren Vertiefungen 121 für LED-Chips 2, mittels denen eine LED-Matrix gebildet wird. Mittels Ätztechnik oder Laserbehandlung sind die Metallbahnen 10 segmentiert. In der oberen Reihe sind die Metallbahnen 10 durch vertikal verlaufende Laserschnitte 91 aufgetrennt, wodurch Anschlussleitungen 101, 102 geschaffen wurden, an die die LED-Chips 2 in Serieschaltung anschliessbar sind. In der unteren Reihe sind die Metallbahnen 10 durch einen horizontal verlaufenden, durch Ätztechnik oder Laserbehandlung gefertigten Schnitt 92 aufgetrennt, wodurch Anschlussleitungen geschaffen wurden, an die LED-Chips 2 in Parallelschaltung anschliessbar sind.

Schematisch gezeigt sind ferner die Biegenut 125 und ein Schnitt 126, die es erlauben, ein Teil 1A des isolierten Metallsubstrats 1 nach unten zu biegen. Mittels des Teils 1A oder der Teile 1A und 1C kann beispielsweise seitliche Lichtabstrahlung bewirkt werden, was bei Verkehrssignalen, beispielsweise bei einem Autoblinker, oft notwendig ist.

In Figur 6 ist ferner gezeigt, dass elektrische Bahnen 10, 1050 im Bereich der Biegezonen vorzugsweise schlangenförmig oder zackenförmig ausgestaltet sind, so dass sie, unter Vermeidung von Unterbrüchen oder Haarrissen, beim Biegen des isolierten Metallsubstrats 1 leicht dehnbar sind. Eine verbesserte Dehnbarkeit kann ferner erzielt werden, indem aus elastischem Material bestehende Isolationsschichten 11 verwendet werden. Die Verwendung dieser Bahnformen 1050 ist insbesondere bei einem mehrschichtigen Aufbau des isolierten Metallsubstrats 1 besonders vorteilhaft, bei dem Brückenelemente 1051 nicht einsetzbar sind. Die schlangenförmig verlaufenden Bahnen 1050 bilden daher eine kostengünstig realisierbare Alternative zu den oben beschriebenen dehnbaren Brückenelementen 1051.

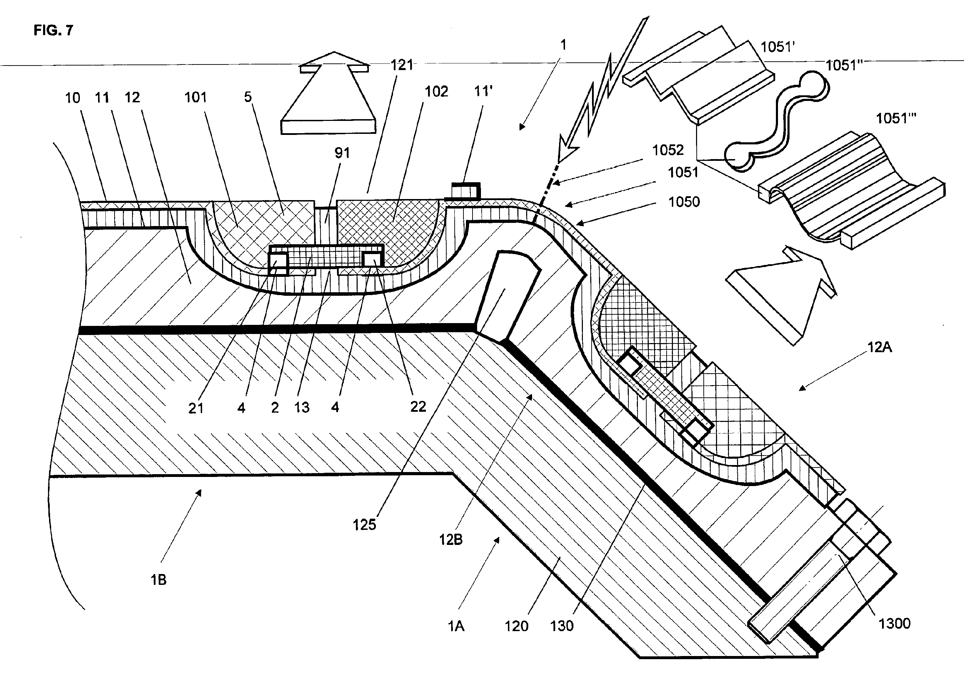

Figur 7 zeigt das isolierte Metallsubstrat 1 von Figur 6, nach dem gegenseitigen Biegen der Teile 1A und 1B und nach der anschliessenden Montage auf dem Metallelement 120, die mittels einer Lötschicht 130 und mittels einer Schraube 1300 erfolgt ist. Aufgrund der guten thermischen Leitfähigkeit genügt es dabei, das Metallsubstrat 12 und das Metallelement 120 nur partiell zu verlöten oder nur zu verschrauben und nicht zu verlöten.

Figur 7 zeigt ferner, dass im Bereich der Biegezone nur eine Isolationsschicht 10 vorgesehen ist und die weiteren Isolationsschichten 11', ... nicht in die Biegezone hineingeführt sind. Dadurch wird verhindert, dass durch das Biegen des isolierten Metallsubstrats 1 Spannungen auf die entsprechenden Schichten übertragen werden. Alternativ ist es auch möglich, einzelne oder alle Schichten 10, 10', ...; 11, 11', ... beispielsweise mittels eines Lasers vorzugsweise entlang der Biegelinie aufzutrennen (siehe den schematisch dargestellten Unterbruch in den Schichten 10 und 11). Sofern dehnbare, schlangenförmig verlaufende Bahnen 1050 verwendet werden, werden die entsprechenden Schichten 10, 11 natürlich nicht aufgetrennt.

Figur 7 zeigt die beiden grundsätzlichen Alternativen zur Realisierung elektrischer Verbindungen, welche die Biegezone durchlaufen. Einerseits können die elektrischen Bahnen 10 durchgezogen und mit einer dehnbaren Form 1050 versehen werden. Andererseits sind dehnbare Brückenelemente 1051, 1051', 1051" , 1051''' verwendbar, die in der Biegezone mit den gegebenenfalls unterbrochenen Bahnen 10 verbunden werden. Die Brückenelemente 1051 können beispielsweise in Form dünner gefalteter Platten 1051', nicht gerade verlaufender, vorzugsweise schlangenförmiger Stäbe oder Drähte 1051" oder als Bänder 1051''' vorliegen, die mit lötbaren Anschlüssen versehen sind.

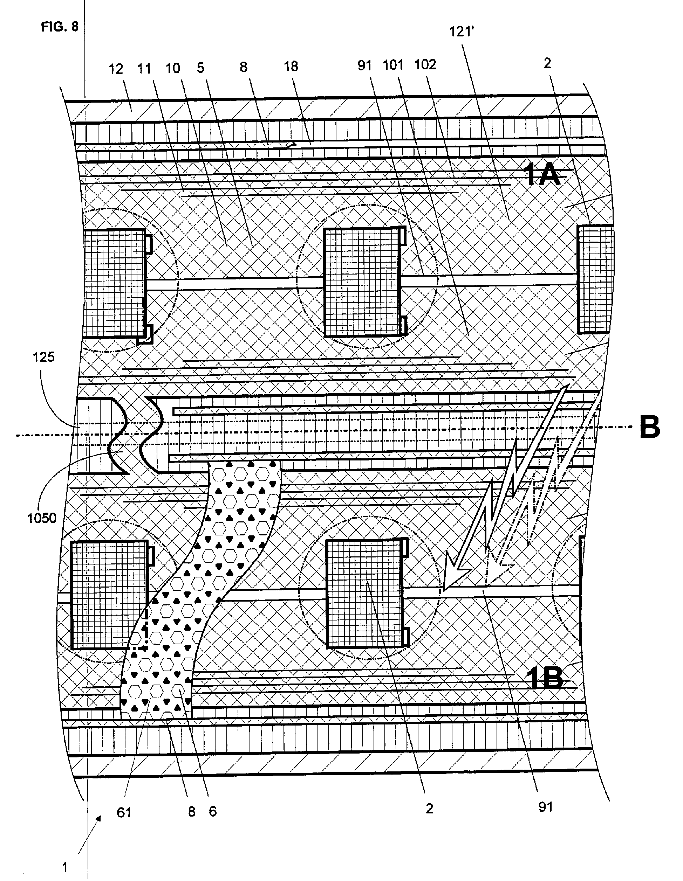

Figur 8 zeigt ein zur Bildung einer LED-Matrix dienendes isoliertes Metallsubstrat 1 mit zwei kanalförmigen Vertiefungen 121', in denen LED-Chips 2 mit hoher Packungsdichte montierbar sind. In den Vertiefungen 121' wurde die zur Bildung der Metallbahnen 10 dienende Metallschicht durch horizontal verlaufende Schnitte 91 segmentiert, so dass Reflektorflächen 5 bildende Anschlussleitungen 101, 102 geschaffen wurden, mittels denen die montierten LED-Chips 2 parallel schaltbar sind.

Die von den LED-Chips 2 abgegebene Strahlung kann ferner, nach dem Lichtleiter-Prinzip, durch ein in die Vertiefungen 121, 121' eingefülltes, glasähnliches Material in eine gewünschte Richtung gelenkt werden.

Zwischen den kanalförmigen Vertiefungen 121' ist eine Biegenut 125 vorgesehen, die es erlaubt, die beiden Teile 1A und 1B des isolierten Metallsubstrats 1 gegeneinander zu biegen. Ferner gezeigt ist eine die Biegezone kurvenförmig durchlaufende und daher dehnbare elektrische Bahn 10, 1050.

Kanalförmige Vertiefungen können ferner bei den in Figur 3 und Figur 4 gezeigten Ausgestaltungen des integrierten Metallsubstrats 1 verwendet werden, bei denen der LED-Chip 2 mit dem Metallsubstrat 12 direkt verbunden ist.

Die untere kanalförmige Vertiefung 121' ist ferner mit einem Medium 6 gefüllt, das fluoreszierende Elemente 61 enthält. Mittels dieses Mediums 6 wird der von der Wellenlänge abhängige Intensitätsverlauf der abgegebenen Strahlung linearisiert. Nebst der Linearisierung des Intensitätsverlaufs bewirkt das in die Vertiefungen 121' eingefüllte vorzugsweise gut wärmeleitende Medium 6 zudem einen weiter verbesserten Transfer der Verlustwärme.

Der Wellenlängenverlauf der abgegebenen Strahlung ist ferner von der Form des eingefüllten Mediums 6 abhängig. Sofern das eingefüllte Medium 6 ungehemmt über die Oberfläche des isolierten Metallsubstrats 1 fliesst, resultieren unterschiedliche Formen und somit unterschiedliche optische Systeme. Es besteht daher die Möglichkeit, vorgefertigte optische Linsen (siehe [3]) oder Formelemente zu verwenden, in denen das Medium 6 bis zum Aushärten gehalten wird. Erfindungsgemäss werden auf dem isolierten Metallsubstrat 1 hingegen Grenzelemente 8 vorgesehen, welche die Vertiefungen 121; 121' zumindest teilweise umrahmen und somit als Fliessgrenzen für das in die Vertiefungen 121; 121' eingefüllte Medium 6, beispielsweise ein Harz, dienen, welches durch die Oberflächenspannung in der gewünschten Form gehalten wird. In Figur 3 ist gezeigt, dass das Medium 6 durch die schematisch dargestellten Grenzelemente 8 gestoppt wird. Schematisch gezeigt ist ferner ein Medium 6', das bei Fehlen von Grenzelementen 8 weiter fliessen würde. Aufgrund der Oberflächenspannung des Mediums 6 genügt es, wenn das gegebenenfalls mehrteilige Grenzelemente 8 die Vertiefung 121, 121' nur teilweise bzw. segmentweise begrenzt. In den Figuren 6 und 8 ist gezeigt, dass die Grenzelemente 8 besonders vorteilhaft realisiert werden können, indem auf der Isolationsschicht 11, zusätzlich zu den elektrischen Bahnen 10, Metallsegmente 8 in die Metallschicht eingeätzt werden, die als Grenzelemente 8 dienen. Diese Metallsegmente 8 sind vorzugsweise mit wenigstens einer Schicht, beispielsweise einem Lötstoplack, bedeckt, durch die eine erhöhte Barrierenwirkung erzielt wird. Ferner können aus leitendem oder nichtleitendem Material bestehende Grenzelemente 8 auch in anderer Weise auf das isolierte Metallsubstrat 1 aufgebracht werden.

Zur Optimierung der Eigenschaften des isolierten Metallsubstrats 1 sind verschiedene Materialien vorteilhaft einsetzbar. Beispielsweise sind Metallsubstrate aus Kupfer oder Aluminiumlegierungen verwendbar. Vorzugsweise wird eine mit Silizium oder mit Silizium und Magnesium versehene Aluminiumlegierung verwendet, deren Ausdehnungskoeffizient bzw. Wärmedehnungskoeffizient im Bereich von 17 ppm/K oder darunter liegt. Dies erlaubt die Montage bzw. das Verlöten von Keramikbauteilen auf der Oberfläche des isolierten Metallsubstrats 1, ohne dass anschliessend beim Durchlaufen von Temperaturgradienten, aufgrund von Wärmedehnungen, Brüche der Lötstellen oder des Keramikkörpers auftreten.

Die auf der Isolationsschicht 11 vorgesehenen elektrischen Bahnen 10 können aus hochwertigen Metallen wie Gold, Silber, Kupfer, Nickel, Palladium oder entsprechenden Legierungen oder, bevorzugt, aus einem gut leitenden Material wie Kupfer bestehen, das mit diesen hochwertigen Metallen beschichtet ist. Die Veredelung kann gleichzeitig in den Vertiefungen 121, 121', auf den Anschlusskontakten 15 und auf der ist. Die Veredelung kann gleichzeitig in den Vertiefungen 121, 121', auf den Anschlusskontakten 15 und auf der Unterseite des Metallsubstrats 12 vollflächig oder partiell aufgebracht werden. Die Veredelung ist lötbar, bondbar und stört optisch in den Vertiefungen 121, 121' nicht bzw. reflektiert nach Bedarf.

Die erfindungsgemässe Kabelführungsvorrichtung 1 würde in bevorzugten Ausgestaltungen beschrieben und dargestellt. Anhand der erfindungsgemässen Lehre sind jedoch weitere fachmännische Ausgestaltungen realisierbar. Insbesondere sind die dargestellten Lösungselemente leicht miteinander kombinierbar.

### Literaturverzeichnis

[1] U.S. Patent 6,498,355
[2] U.S. Patent 5,513,072
[3] U.S. Patent 4,935,665
[4] WO 03/030274
[5] WO 03/030274

## Patentansprüche

1. Isoliertes Metallsubstrat (1) bestehend aus einem mit mehreren Vertiefungen (121, 121') versehenen Metallsubstrat (12), an dessen Oberseite (12A) eine Isolationsschicht (11) mit elektrischen Bahnen (10) angeordnet ist, an die mehrere gegebenenfalls in Chip-Form vorliegende, innerhalb der Vertiefungen (121, 121') angeordnete Leuchtdioden (2) angeschlossen sind, **dadurch gekennzeichnet, dass** n gegeneinander geneigte Teile (1A, 1B) des Metallsubstrats (12) zumindest teilweise durch in die Unterseite (12B) des Metallsubstrats (12) eingearbeitete Materialausnehmungen (125) voneinander getrennt sind, die Biegezonen bilden, und dass die gegebenenfalls beschichteten Vertiefungen (121, 121') derart an der Oberseite (12A) in das Metallsubstrat (12) der Teile (1A, 1B) eingearbeitet sind, dass die Teile (1A, 1B) des Metallsubstrats (12) an der Unterseite (12B) ebene Flächen aufweisen, die mit wenigstens einem Metallelement (120) verbunden oder verbindbar sind, welches die von den Leuchtdioden (2) abgegebene und durch das Metallsubstrat (12) transferierte Wärmeenergie absorbiert

2. Isoliertes Metallsubstrat (1) nach Anspruch 1, **dadurch gekennzeichnet, dass** das Metallsubstrat (12) und das Metallelement (120) miteinander verschraubt oder verlötet sind und/oder dass wenigstens ein elektrischer Anschlusskontakt (21, 22) oder ein thermischer Anschlusskontakt (23) der LED-Chips (2) mit dem Metallsubstrat (12) verbunden, vorzugsweise verlötet ist.

3. Isoliertes Metallsubstrat (1) nach Anspruch 1 oder 2, **dadurch gekennzeichnet, dass** die Dicke (d12) des Metallsubstrats (12) etwa der Tiefe (d121) der Vertiefungen (121, 121') entspricht oder nur soviel grösser ist, als es für die stabile Montage der Leuchtdioden (2) erforderlich ist.

4. Isoliertes Metallsubstrat (1) nach Anspruch 1, 2 oder 3, **dadurch gekennzeichnet, dass** elektrische Bahnen (10, 10'; 1050) im Bereich möglicher Biegezonen auf der zugehörigen Isolationsschicht (11, 11') schräg verlaufend, kurvenförmig, zackenförmig oder, teilweise von der zugehörigen Isolationsschicht (11, 11') getrennt, brückenförmig angeordnet sind und/oder dass im Bereich möglicher Biegezonen dehnbare, elektrisch leitende Bauelemente (1051), wie dehnbar geformte Platten (1051'); Drähte (1051") oder Bänder (1051"'), zur Überbrückung der elektrischen Bahnen (10; 10') vorgesehen sind.

5. Isoliertes Metallsubstrat (1) nach einem der Ansprüche 1 bis 4, **dadurch gekennzeichnet, dass** die Vertiefungen (121, 121') rund, oval oder kanalförmig ausgestaltet sind.

6. Isoliertes Metallsubstrat (1) nach einem der Ansprüche 1 bis 5, **dadurch gekennzeichnet, dass** an der Oberseite (12A) des Metallsubstrats (12) wenigstens zwei übereinander liegende erste bzw. zweite Isolationsschichten (11, 11') mit elektrischen Bahnen (10, 10') angeordnet sind, von denen einzelne mittels Vias (15), die wenigstens eine der Isolationsschichten (11') durchdringen, miteinander verbunden sind.

7. Isoliertes Metallsubstrat (1) nach Anspruch 6, **dadurch gekennzeichnet, dass** die elektrischen Bahnen (10) der ersten Schicht (11) mit den Leuchtdioden (2) verbunden sind und dass die elektrischen Bahnen (10') der weiteren Schichten (11', ...) mit weiteren elektrischen und elektronischen Bauteilen (200) verbunden sind.

8. Isoliertes Metallsubstrat (1) nach einem der Ansprüche 1 bis 7, **dadurch gekennzeichnet, dass** das isolierte mit Keramikbauteilen (200) bestückte Metallsubstrat (1) ein Metallsubstrat (12) aufweist, das aus einer mit Silizium oder mit Silizium und Magnesium versehenen Aluminiumlegierung besteht, deren Ausdehnungskoeffizient im Bereich von 17 ppm/K oder darunter liegt.

9. Isoliertes Metallsubstrat (1) nach einem der Ansprüche 1 bis 8, **dadurch gekennzeichnet, dass** die Vertiefungen (121; 121') zumindest teilweise mittels Grenzelementen (8) begrenzt sind, die als Fliessgrenzen für das in die Vertiefungen (121; 121') eingefüllte Medium (6), wie Harz, dienen.

## Claims

1. Insulated metal substrate (1) consisting of a metal substrate (12) with a plurality of recesses (121, 121') and with an upper side (12A) on which an insulating layer (11) with electrical traces is arranged, which are connected to a plurality of light emitting diodes (2), which are optionally present in chip-form and which are arranged within the recesses (121, 121'), **characterised in that** n portions (1A, 1B) of the metal substrate (12), which are inclined towards one another, are at least partially separated from one another by clearances of material (125) that are worked into the lower side (12B) of the metal substrate (12) and that form bending areas, and that the recesses (121, 121'), which are optionally provided with a layer, are worked on the upper side (12A) in such a way into the metal substrate (12) of the portions (1A, 1B), that the portions (1A, 1B) of the metal substrate (12) on the lower side (12B) exhibit planar surfaces, which are connected or connectable to at least one metal part (120), which absorbs the thermal energy that is delivered by the light emitting diodes (2) and transferred through the metal substrate (12).

2. Insulated metal substrate (1) according to claim 1, **characterised in that** the metal substrate (12) and the metal part (120) are soldered or screwed to one another and/or that at least an electrically connecting contact (21, 22) or a thermally connecting contact (23) of the LED-chip (2) is connected, preferably soldered to the metal substrate (12).

3. Insulated metal substrate (1) according to claim 1 or 2, **characterised in that** the thickness (d12) of the metal substrate (12) corresponds approximately to the depth (d121) of the recesses (121, 121') or is only as much larger, as required for the stable mounting of the light emitting diodes (2).

4. Insulated metal substrate (1) according to claim 1, 2 or 3, **characterised in that** electrical traces (10, 10'; 1050) in the range of possible bending areas are arranged sloped, curved, spike-formed on the related insulating layer (11, 11') or are, partially separated from the related insulating layer (11, 11'), arranged arched and/or that expandable electrically conducting components (1051), such as plates with expandable forms (1051'), wires (1051") or ribbons (1051'"), are arranged in the region of the bending areas, for bridging the electrical traces (10; 10').

5. Insulated metal substrate (1) according to one of the claims 1 - 4, **characterised in that** the recesses (121, 121') are designed round, oval or channel-like.

6. Insulated metal substrate (1) according to one of the claims 1 - 5, **characterised in that** on the upper side (12A) of the metal substrate (12) at least two first and second insulating layers (11, 11') with electrical traces (10, 10') are arranged on top of one another, of which some of them are connected with one another by means of vias (15), which protrude at least one of the insulating layers (11').

7. Insulated metal substrate (1) according to claim 6, **characterised in that** the electrical traces (10) of the first layer (11) are connected with the light emitting diodes (2) and that the electrical traces (10') of the further layers (11', ...) are connected with further electrical or electronic components (200).

8. Insulated metal substrate (1) according to one of the claims 1 - 7, **characterised in that** the insulated metal substrate (1), which is equipped with ceramic components (200), comprises a metal substrate (12), which consist of an aluminium alloy that comprises silicium or silicium and magnesium, and that has a coefficient of expansion in the range of 17 ppm/K or below.

9. Insulated metal substrate (1) according to one of the claims 1 - 8, **characterised in that** the recesses (121; 121') are delimited at least partially with peripheral elements (8) that serve as flow barriers for the medium (6), such as resin, filled into the recesses (121; 121').

## Revendications

1. Substrat métallique isolé (1) se composant d'un substrat métallique (12) muni de plusieurs évidements (121, 121') sur la face supérieure (12A) duquel est disposée une couche d'isolation (11) avec des pistes électriques (10) aux quelles sont raccordées plusieurs diodes lumineuses (2) disposées éventuellement en forme de puce à l'intérieur des évidements (121, 121') **caractérisé en ce que** n pièces (1A, 1B) inclinées les unes vers les autres du substrat métallique (12) sont séparées les unes des autres au moins partiellement par des cavités de matière (125) ménagées dans la face inférieure (12B) du substrat métallique (12), lesquelles forment des zones de flexion et **en ce que** les évidements (121, 121'), éventuellement revêtus d'une couche, sont ménagés dans le substrat métallique (12) des parties (1A, 1B) de sorte que les parties (1A, 1B) du substrat métallique (12) présentent sur la face inférieure (12B) des surfaces planes qui sont reliées ou reliables à au moins un élément métallique (120), lequel absorbe l'énergie thermique dégagée par les diodes lumineuses (2) et transférée par le substrat métallique (12).

2. Substrat métallique isolé (1) selon la revendication 1, **caractérisé en ce que** le substrat métallique (12) et l'élément métallique (120) sont vissés ou brasés entre eux et/ou **en ce qu'**au moins un contact de connexion électrique (21, 22) ou un contact de connexion thermique (23) des puces DEL (2) est relié de préférence brasé au substrat métallique (12).

3. Substrat métallique isolé (1) selon la revendication 1, **caractérisé en ce que** l'épaisseur (d12) du substrat métallique (12) correspond approximativement à la profondeur (d121) des évidements (121, 121') ou n'est supérieure que de ce qui est nécessaire pour le montage stable des diodes lumineuses (2).

4. Substrat métallique isolé (1) selon la revendication 1, 2 ou 3, **caractérisé en ce que** des pistes électriques (10, 10'; 1050) sont disposées proximité de zones de flexion possibles sur la couche d'isolation respective (11, 11'), de manière inclinée, en forme de courbe, de pointe ou partiellement séparée de la couche d'isolation respective (11, 11'), en forme de pont, et/ou **en ce qu'**à proximité de zones de flexion possibles, il est prévu des éléments de construction extensibles, électriquement conducteurs (1051) tels que des plaques extensibles électriquement conductrices (1051'), des fils (1051") ou des bandes (1051"'), pour le franchissement des pistes électriques(10 ; 10').

5. Substrat métallique isolé (1) selon l'une des revendications 1 à 5, **caractérisé en ce que** les évidements (121, 121') sont réalisés ronds, ovale ou en forme de canal.

6. Substrat métallique isolé (1) selon la revendication 6, **caractérisé en ce que** sur la face supérieure (12A) du substrat métallique (12), il est disposé au moins deux premières et secondes couches d'isolation (11, 11') superposées comprenant des pistes électriques (10, 10') dont certaines sont reliés par Vias (15) qui traversent au moins l'une des couches d'isolation (11')

7. Substrat métallique isolé (1) selon la revendication 6, **caractérisé en ce que** les pistes électriques (10) de la première couche (11) sont reliées aux diodes lumineuses (2) et **en ce que** les pistes électriques (10') des autres couches (11',..) sont reliées à d'autres composants électriques et électroniques (200).

8. Substrat métallique isolé (1) selon l'une des revendications 1 à 7, **caractérisé en ce que** le substrat métallique (1) isolé et garni de composants céramiques (200) présente un substrat métallique (12) qui se compose d'un alliage d'aluminium doté de silicium ou de silicium et de magnésium, dont le coefficient de dilatation est inférieur ou égal à 17 ppm/K.

9. Substrat métallique isolé (1) selon l'une des revendications 1 à 8, **caractérisé en ce que** les évidements (121, 121') sont limités du moins partiellement au moyen d'éléments de délimitation (8) qui servent de limites d'écoulement pour le fluide (6), tel que la résine, rempli dans les évidements (121, 121').
